# EUROPEAN PATENT APPLICATION

(11) **EP 4 530 723 A2**
(43) Date of publication of application: **02.04.2025**
(21) Application number: 24202403.2
(22) Date of filing: 25.09.2024
(51) Int. Cl.: G03F 7/20, G03F 1/36

(54) **ADAPTIVE TARGET CONTROL FOR CURVILINEAR OPTICAL PROXIMITY CORRECTION (OPC)**

(30) Priority: 27.09.2023 US 202318475362
(71) Applicant: Siemens Industry Software Inc., Plano, TX 75024 (US)
(72) Inventor: LIPPINCOTT, George P., Lake Oswego, OR, 97034 (US); KAUR, Avneet, Fremont, CA, 94539 (US)
(74) Representative: Horn Kleimann Waitzhofer Schmid-Dreyer Patent- und Rechtsanwälte PartG mbB

(57) **Abstract**

Aspects of the disclosed technology relate to techniques for achieving optical proximity correction. Anchor points in a layout design may be designated as more important or less important. Optical proximity correction iterations are performed on each of the plurality of regions to generate a modified layout design by processing the more important anchor points differently than the less important anchor points, such as by different weighting or by dynamically changing the target for the less important anchor points. In this way, the edge placement error may be reduced or eliminated for the more important anchor points.

## Description

### FIELD

The present disclosed technology relates to the field of circuit design and manufacture. Various implementations of the disclosed technology may be particularly useful for optical proximity correction of layout designs.

### BACKGROUND

As designers and manufacturers continue to shrink the size of circuit components, the shapes produced on a substrate through photolithography become smaller and are placed closer together. This reduction in feature size and spacing increases the difficulty of accurately reproducing the image intended by the design layout onto the substrate and can create flaws in the manufactured device. To address the problem, one or more resolution enhancement techniques are often employed to improve the resolution of the image that a photolithographic mask forms on the substrate during the photolithographic process.

One of resolution enhancement techniques, "optical proximity correction" or "optical process correction" (OPC), tries to compensate for light diffraction effects. When light illuminates the photomask, the transmitted light diffracts, with light from regions with higher special frequencies diffracting at higher angles. The resolution limits of the lens in a photolithographic system make the lens act effectively as a low-pass filter for the various spatial frequencies in the two-dimensional layout. This can lead to optical proximity effects such as a pull-back of line-ends from their desired position, corner rounding, and a bias between isolated and dense structures. The optical proximity correction adjusts the amplitude of the light transmitted through a lithographic mask by modifying the layout design data employed to create the photomask. For example, edges in the layout design may be adjusted to make certain portions of the geometric elements larger or smaller, in accordance with how much additional light exposure (or lack of exposure) is desired at certain points on the substrate. When these adjustments are appropriately calibrated, overall pattern fidelity is greatly improved, reducing optical proximity effects.

One such OPC technique is curvilinear OPC. In curvilinear OPC, locations are measured to determine whether the image is on-target in order to generate the curved-target. The curved-target may begin from a non-curved design with the shape of the curve being a prediction of what the final result may look like.

### BRIEF DESCRIPTION OF THE DRAWINGS

The accompanying drawings, which are incorporated in and constitute a part of this specification, illustrate various aspects of the disclosure and together with the description, serve to explain its principles. Wherever convenient, the same reference numbers will be used throughout the drawings to refer to the same or like elements.
FIG. 1 illustrates an example of a computing system that may be used to implement various embodiments of the disclosed technology.
FIG. 2 illustrates an example of a multi-core processor unit that may be used to implement various embodiments of the disclosed technology.
FIG. 3A illustrates a mask feature and a simulated image of the mask feature.
FIG. 3B illustrates an example of fragmentation of an edge of the mask feature.
FIG. 3C illustrates edge displacement errors for some of the edge fragments.
FIG. 3D illustrates a mask feature modified from the mask feature by an OPC process and a corresponding simulated image.
FIG. 4 illustrates an example of an optical proximity correction tool according to various embodiments of the disclosed technology.
FIG. 5 illustrates a flowchart showing a process of optical proximity correction that may be implemented according to various examples of the disclosed technology.
FIGS. 6A-B schematically illustrate weighted edge placement error (EPE) smoothing in order to reduce EPE.
FIGS. 7A-B schematically illustrate weighted target control in order to reduce EPE.

### DETAILED DESCRIPTION

### General Considerations

Various aspects of the present disclosed technology relate to techniques for achieving optical proximity correction cross-tile consistency. In the following description, numerous details are set forth for the purpose of explanation. However, one of ordinary skill in the art will realize that the disclosed technology may be practiced without the use of these specific details. In other instances, well-known features have not been described in detail to avoid obscuring the present disclosed technology.

Some of the techniques described herein can be implemented in software instructions stored on a computer-readable medium, software instructions executed on a computer, or some combination of both. Some of the disclosed techniques, for example, can be implemented as part of an electronic design automation (EDA) tool. Such methods can be executed on a single computer or on networked computers.

Although the operations of the disclosed methods are described in a particular sequential order for convenient presentation, it should be understood that this manner of description encompasses rearrangements, unless a particular ordering is required by specific language set forth below. For example, operations described sequentially may in some cases be rearranged or performed concurrently. Moreover, for the sake of simplicity, the disclosed flow charts and block diagrams typically do not show the various ways in which particular methods can be used in conjunction with other methods. Additionally, the detailed description sometimes uses terms like "perform", "generate," and "determine" to describe the disclosed methods. Such terms are high-level abstractions of the actual operations that are performed. The actual operations that correspond to these terms will vary depending on the particular implementation and are readily discernible by one of ordinary skill in the art.

Also, as used herein, the term "design" is intended to encompass data describing an entire integrated circuit device. This term also is intended to encompass a smaller group of data describing one or more components of an entire device, however, such as a portion of an integrated circuit device. Still further, the term "design" also is intended to encompass data describing more than one micro device, such as data to be used to form multiple micro devices on a single wafer.

### Illustrative Operating En vironment

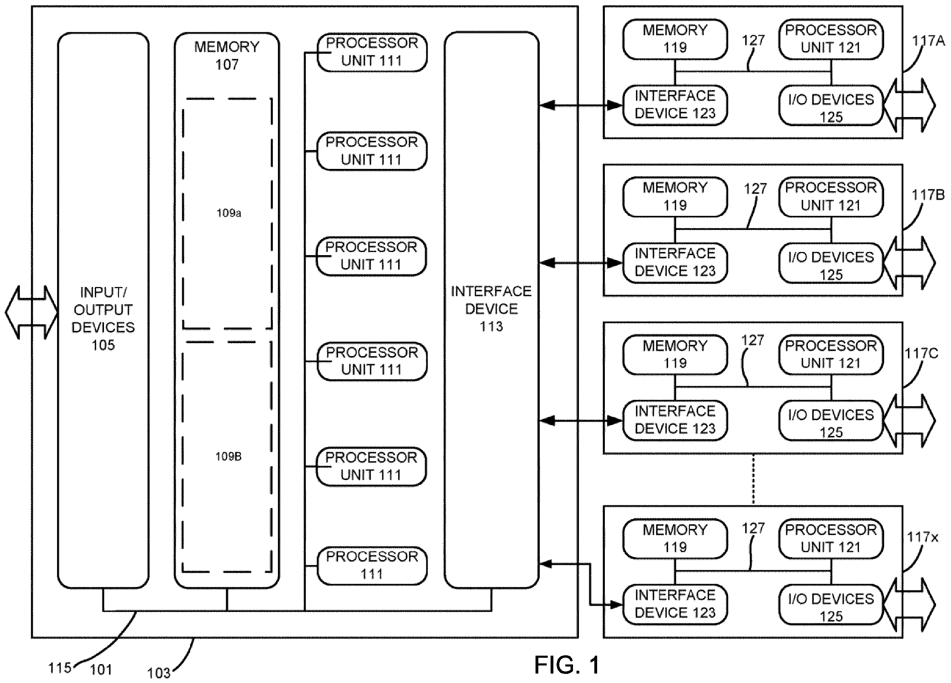

The execution of various electronic design automation processes according to embodiments of the disclosed technology may be implemented using computer-executable software instructions executed by one or more programmable computing devices. Because these embodiments of the disclosed technology may be implemented using software instructions, the components and operation of a generic programmable computer system on which various embodiments of the disclosed technology may be employed will first be described. Further, because of the complexity of some electronic design automation processes and the large size of many circuit designs, various electronic design automation tools are configured to operate on a computing system capable of simultaneously running multiple processing threads. The components and operation of a computer network having a host or master computer and one or more remote or servant computers therefore will be described with reference to FIG. 1. This operating environment is only one example of a suitable operating environment, however, and is not intended to suggest any limitation as to the scope of use or functionality of the disclosed technology.

In FIG. 1, the computer network 101 includes a master computer 103. In the illustrated example, the master computer 103 is a multiprocessor computer that includes a plurality of input/output devices 105 and a memory 107. The input/output devices 105 may include any device for receiving input data from or providing output data to a user. The input devices may include, for example, a keyboard, microphone, scanner or pointing device for receiving input from a user. The output devices may then include a display monitor, speaker, printer or tactile feedback device. These devices and their connections are well known in the art, and thus will not be discussed at length here.

The memory 107 may similarly be implemented using any combination of computer readable media that can be accessed by the master computer 103. The computer readable media may include, for example, microcircuit memory devices such as read-write memory (RAM), read-only memory (ROM), electronically erasable and programmable read-only memory (EEPROM) or flash memory microcircuit devices, CD-ROM disks, digital video disks (DVD), or other optical storage devices. The computer readable media may also include magnetic cassettes, magnetic tapes, magnetic disks or other magnetic storage devices, punched media, holographic storage devices, or any other medium that can be used to store desired information.

As will be discussed in detail below, the master computer 103 runs a software application for performing one or more operations according to various examples of the disclosed technology. Accordingly, the memory 107 stores software instructions 109A that, when executed, will implement a software application for performing one or more operations. The memory 107 also stores data 109B to be used with the software application. In the illustrated embodiment, the data 109B contains process data that the software application uses to perform the operations, at least some of which may be parallel.

The master computer 103 also includes a plurality of processor units 111 and an interface device 113. The processor units 111 may be any type of processor device that can be programmed to execute the software instructions 109A, but will conventionally be a microprocessor device. For example, one or more of the processor units 111 may be a commercially generic programmable microprocessor, such as Intel^{®} Pentium^{®} or Xeon^{™} microprocessors, Advanced Micro Devices Athlon^{™} microprocessors or Motorola 68K/Coldfire^{®} microprocessors. Alternately or additionally, one or more of the processor units 111 may be a custom-manufactured processor, such as a microprocessor designed to optimally perform specific types of mathematical operations. The interface device 113, the processor units 111, the memory 107 and the input/output devices 105 are connected together by a bus 115.

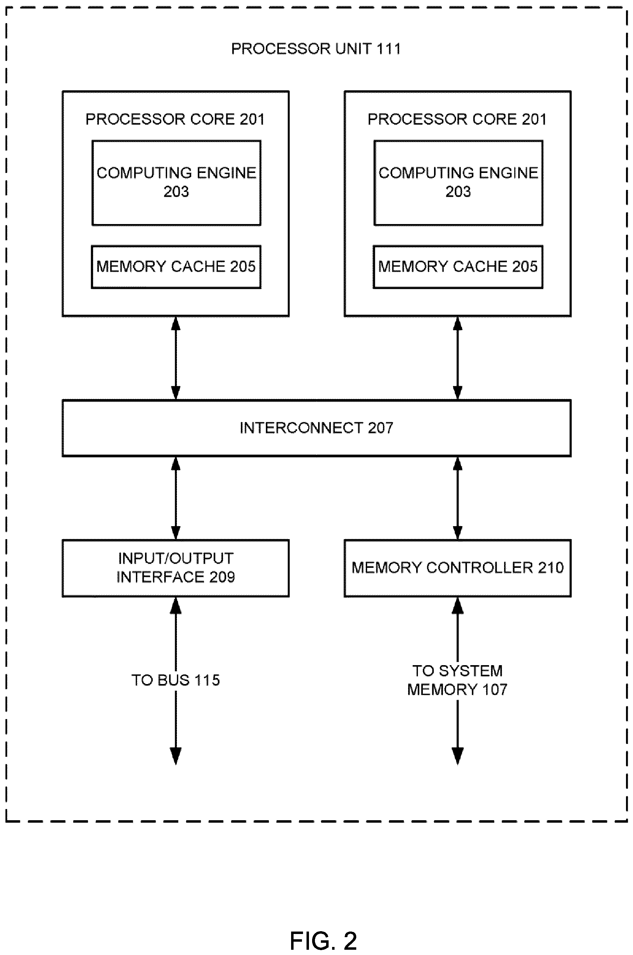

With some implementations of the disclosed technology, the master computer 103 may employ one or more processing units 111 having more than one processor core. Accordingly, FIG. 2 illustrates an example of a multi-core processor unit 111 that may be employed with various embodiments of the disclosed technology. As seen in this figure, the processor unit 111 includes a plurality of processor cores 201. Each processor core 201 includes a computing engine 203 and a memory cache 205. As known to those of ordinary skill in the art, a computing engine contains logic devices for performing various computing functions, such as fetching software instructions and then performing the actions specified in the fetched instructions. These actions may include, for example, adding, subtracting, multiplying, and comparing numbers, performing logical operations such as AND, OR, NOR and XOR, and retrieving data. Each computing engine 203 may then use its corresponding memory cache 205 to quickly store and retrieve data and/or instructions for execution.

Each processor core 201 is connected to an interconnect 207. The particular construction of the interconnect 207 may vary depending upon the architecture of the processor unit 111. With some processor cores 201, such as the Cell microprocessor created by Sony Corporation, Toshiba Corporation and IBM Corporation, the interconnect 207 may be implemented as an interconnect bus. With other processor units 111, however, such as the Opteron^{™} and Athlon^{™} dual-core processors available from Advanced Micro Devices of Sunnyvale, Calif., the interconnect 207 may be implemented as a system request interface device. In any case, the processor cores 201 communicate through the interconnect 207 with an input/output interface 209 and a memory controller 210. The input/output interface 209 provides a communication interface between the processor unit 111 and the bus 115. Similarly, the memory controller 210 controls the exchange of information between the processor unit 111 and the system memory 107. With some implementations of the disclosed technology, the processor units 111 may include additional components, such as a high-level cache memory accessible shared by the processor cores 201.

While FIG. 2 shows one illustration of a processor unit 111 that may be employed by some embodiments of the disclosed technology, it should be appreciated that this illustration is representative only, and is not intended to be limiting. Also, with some implementations, a multi-core processor unit 111 can be used in lieu of multiple, separate processor units 111. For example, rather than employing six separate processor units 111, an alternate implementation of the disclosed technology may employ a single processor unit 111 having six cores, two multi-core processor units each having three cores, a multi-core processor unit 111 with four cores together with two separate single-core processor units 111, etc.

Returning now to FIG. 1, the interface device 113 allows the master computer 103 to communicate with the servant computers 117A, 117B, 117C .. . 117x through a communication interface. The communication interface may be any suitable type of interface including, for example, a conventional wired network connection or an optically transmissive wired network connection. The communication interface may also be a wireless connection, such as a wireless optical connection, a radio frequency connection, an infrared connection, or even an acoustic connection. The interface device 113 translates data and control signals from the master computer 103 and each of the servant computers 117 into network messages according to one or more communication protocols, such as the transmission control protocol (TCP), the user datagram protocol (UDP), and the Internet protocol (IP). These and other conventional communication protocols are well known in the art, and thus will not be discussed here in more detail.

Each servant computer 117 may include a memory 119, a processor unit 121, an interface device 123, and, optionally, one more input/output devices 125 connected together by a system bus 127. As with the master computer 103, the optional input/output devices 125 for the servant computers 117 may include any conventional input or output devices, such as keyboards, pointing devices, microphones, display monitors, speakers, and printers. Similarly, the processor units 121 may be any type of conventional or custom-manufactured programmable processor device. For example, one or more of the processor units 121 may be commercially generic programmable microprocessors, such as Intel^{®} Pentium^{®} or Xeon^{™} microprocessors, Advanced Micro Devices Athlon^{™} microprocessors or Motorola 68K/Coldfire^{®} microprocessors. Alternately, one or more of the processor units 121 may be custom-manufactured processors, such as microprocessors designed to optimally perform specific types of mathematical operations. Still further, one or more of the processor units 121 may have more than one core, as described with reference to FIG. 2 above. For example, with some implementations of the disclosed technology, one or more of the processor units 121 may be a Cell processor. The memory 119 then may be implemented using any combination of the computer readable media discussed above. Like the interface device 113, the interface devices 123 allow the servant computers 117 to communicate with the master computer 103 over the communication interface.

In the illustrated example, the master computer 103 is a multiprocessor unit computer with multiple processor units 111, while each servant computer 117 has a single processor unit 121. It should be noted, however, that alternate implementations of the disclosed technology may employ a master computer having single processor unit 111. Further, one or more of the servant computers 117 may have multiple processor units 121, depending upon their intended use, as previously discussed. Also, while only a single interface device 113 or 123 is illustrated for both the master computer 103 and the servant computers, it should be noted that, with alternate embodiments of the disclosed technology, either the master computer 103, one or more of the servant computers 117, or some combination of both may use two or more different interface devices 113 or 123 for communicating over multiple communication interfaces.

With various examples of the disclosed technology, the master computer 103 may be connected to one or more external data storage devices. These external data storage devices may be implemented using any combination of computer readable media that can be accessed by the master computer 103. The computer readable media may include, for example, microcircuit memory devices such as read-write memory (RAM), read-only memory (ROM), electronically erasable and programmable read-only memory (EEPROM) or flash memory microcircuit devices, CD-ROM disks, digital video disks (DVD), or other optical storage devices. The computer readable media may also include magnetic cassettes, magnetic tapes, magnetic disks or other magnetic storage devices, punched media, holographic storage devices, or any other medium that can be used to store desired information. According to some implementations of the disclosed technology, one or more of the servant computers 117 may alternately or additionally be connected to one or more external data storage devices. Typically, these external data storage devices will include data storage devices that also are connected to the master computer 103, but they also may be different from any data storage devices accessible by the master computer 103.

It also should be appreciated that the description of the computer network illustrated in FIG. 1 and FIG. 2 is provided as an example only, and it not intended to suggest any limitation as to the scope of use or functionality of alternate embodiments of the disclosed technology.

### Circuit Design Flow and Optical Proximity Correction

Electronic circuits, such as integrated microcircuits, are used in a variety of products, from automobiles to microwaves to personal computers. Designing and fabricating integrated circuit devices typically involves many steps, sometimes referred to as a "design flow." The particular steps of a design flow often are dependent upon the type of integrated circuit, its complexity, the design team, and the integrated circuit fabricator or foundry that will manufacture the microcircuit. Typically, software and hardware "tools" verify the design at various stages of the design flow by running software simulators and/or hardware emulators. These steps aid in the discovery of errors in the design, and allow the designers and engineers to correct or otherwise improve the design.

Several steps are common to most design flows. Initially, the specification for a new circuit is transformed into a logical design, sometimes referred to as a register transfer level (RTL) description of the circuit. With this logical design, the circuit is described in terms of both the exchange of signals between hardware registers and the logical operations that are performed on those signals. The logical design typically employs a Hardware Design Language (HDL), such as the Very high speed integrated circuit Hardware Design Language (VHDL). The logic of the circuit is then analyzed, to confirm that it will accurately perform the functions desired for the circuit. This analysis is sometimes referred to as "functional verification."

After the accuracy of the logical design is confirmed, it is converted into a device design by synthesis software. The device design, which is typically in the form of a schematic or netlist, describes the specific electronic devices (such as transistors, resistors, and capacitors) that will be used in the circuit, along with their interconnections. This device design generally corresponds to the level of representation displayed in conventional circuit diagrams. The relationships between the electronic devices are then analyzed, to confirm that the circuit described by the device design will correctly perform the desired functions. This analysis is sometimes referred to as "formal verification." Additionally, preliminary timing estimates for portions of the circuit are often made at this stage, using an assumed characteristic speed for each device, and incorporated into the verification process.

Once the components and their interconnections are established, the design is again transformed, this time into a physical design that describes specific geometric elements. This type of design often is referred to as a "layout" design. The geometric elements, which typically are polygons, define the shapes that will be created in various layers of material to manufacture the circuit. Typically, automated place and route tools will be used to define the physical layouts, especially of wires that will be used to interconnect the circuit devices. Each layer of the microcircuit will have a corresponding layer representation in the layout design, and the geometric shapes described in a layer representation will define the relative locations of the circuit elements that will make up the circuit device. For example, shapes in the layer representation of a metal layer will define the locations of the metal wires used to connect the circuit devices. Custom layout editors, such as Mentor Graphics' IC Station or Cadence's Virtuoso, allow a designer to custom design the layout, which is mainly used for analog, mixed-signal, RF, and standard-cell designs.

Integrated circuit layout descriptions can be provided in many different formats. The Graphic Data System II (GDSII) format is a popular format for transferring and archiving two-dimensional graphical IC layout data. Among other features, it contains a hierarchy of structures, each structure containing layout elements (e.g., polygons, paths or poly-lines, circles and textboxes). Other formats include an open source format named Open Access, Milkyway by Synopsys, Inc., EDDM by Mentor Graphics, Inc., and the more recent Open Artwork System Interchange Standard (OASIS) proposed by Semiconductor Equipment and Materials International (SEMI). These various industry formats are used to define the geometrical information in IC layout designs that are employed to manufacture integrated circuits. Once the microcircuit device design is finalized, the layout portion of the design can be used by fabrication tools to manufacture the device using a photolithographic process.

Typically, a designer will perform a number of verification processes on the layout design. For example, the layout design may be analyzed to confirm that it accurately represents the circuit devices and their relationships described in the device design. In this process, a layout versus schematic (LVS) tool extracts a netlist from the layout design and compares it with the netlist taken from the circuit schematic. LVS can be augmented by formal equivalence checking, which checks whether two circuits perform exactly the same function without demanding isomorphism.

The layout design also may be analyzed to confirm that it complies with various design requirements, such as minimum spacings between geometric elements and minimum linewidths of geometric elements. In this process, a design rule check (DRC) tool takes as input a layout in the GDSII standard format and a list of rules specific to the semiconductor process chosen for fabrication. A set of rules for a particular process is referred to as a run-set, rule deck, or just a deck. An example of the format of a rule deck is the Standard Verification Rule Format (SVRF) by Mentor Graphics Corporation.

There are many different fabrication processes for manufacturing a circuit, but most processes include a series of steps that deposit layers of different materials on a substrate, expose specific portions of each layer to radiation, and then etch the exposed (or non-exposed) portions of the layer away. For example, a simple semiconductor device component could be manufactured by the following steps. First, a positive type epitaxial layer is grown on a silicon substrate through chemical vapor deposition. Next, a nitride layer is deposited over the epitaxial layer. Then specific areas of the nitride layer are exposed to radiation, and the exposed areas are etched away, leaving behind exposed areas on the epitaxial layer, (i.e., areas no longer covered by the nitride layer). The exposed areas then are subjected to a diffusion or ion implantation process, causing dopants, for example phosphorus, to enter the exposed epitaxial layer and form charged wells. This process of depositing layers of material on the substrate or subsequent material layers, and then exposing specific patterns to radiation, etching, and dopants or other diffusion materials, is repeated a number of times, allowing the different physical layers of the circuit to be manufactured.

Each time that a layer of material is exposed to radiation, a mask must be created to expose only the desired areas to the radiation, and to protect the other areas from exposure. The mask is created from circuit layout data. That is, the geometric elements described in a design layout define the relative locations or areas of the circuit that will be exposed to radiation through the mask. A mask or reticle writing tool is used to create the mask based upon the design layout, after which the mask can be used in a photolithographic process.

As discussed previously, one or more resolution enhancement techniques (RETs) are often employed to improve the resolution of the image that the mask forms on the substrate during the photolithographic process. One of these techniques is optical proximity correction (OPC). OPC can be rule-based, model-based, or both. In rule-based OPC, the proximity effects are characterized and specific solutions are devised for specific geometric configurations. The layout design is then searched using a DRC tool or a geometric-based software engine to find these geometric configurations. Once they are found, the specific solutions are applied.

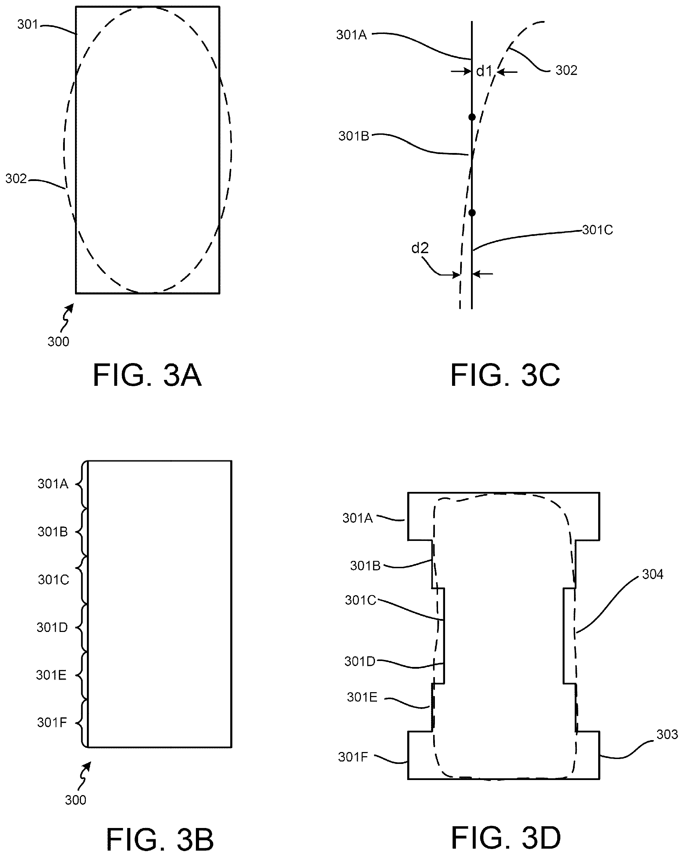

Rule-based OPC approaches work well for simple cases. For complex layout features, however, model-based OPC approaches must be employed to obtain desired results. Model-based OPC performs simulation to predict the printed image, which guides layout modifications. In a typical model-based OPC process, polygons in the layout design are divided into edge fragments to allow the desired fine motion of edge fragments. FIGS. 3A-3D illustrates an example. A geometric element 301, such as an edge, of a layout feature 300 in FIG. 3A may be fragmented into edge fragments 301A-301F as shown in FIG. 3B. The size of the edge fragments and which particular edges are to be fragmented in a given layout design depends upon the OPC process parameters, often referred to as the OPC recipe. While not all edges within a layout design are fragmented in every OPC process, these edges may also be referred to as edge fragments. Simulation is performed to obtain the predicted printed image 302 for the layout feature 300 shown in FIG. 3A. This simulated image is compared to the target image (e.g., a position of the anchor points generated in the simulated image are compared to positions of the target values for the anchor points). An anchor point may refer to any point at which EPE is measured, and anchor points can be selected or determined in any suitable manner. In one or some embodiments, anchor points may comprise a set of points used to define the curve of the layout design (e.g., a respective anchor point may comprise the end-point of a spline segment). In one or some embodiments, the EPE may be measured for one or more of the anchor points. Typically, this comparison is done at each edge fragment. For example, as shown in FIG. 3C, the target image (with targets for different anchor points) is a distance d1 away from the simulated image at the edge fragment 301A (e.g., the target for the edge fragment 301A is d1 away from the simulated image), the target image is a distance d2 away from the simulated image at the edge fragment 301C, while the target image intersects the simulated image at the edge fragment 301B. The distances between the target (e.g., target shape) and the simulated image are often referred to as edge placement error (EPE).

Next, the edge fragments are individually moved or adjusted in order to enable the simulated image for the resulting mask to reproduce the target image as accurately as possible (e.g., by reducing EPE). For example, as shown in FIG. 3D, the edge fragment 301A is displaced in a direction away from the geometric element 301, in an effort to widen the corresponding portion of the image that would be produced by the resulting mask. Similarly, the edge fragment 301C is displaced in a direction toward from the geometric element 301, in an effort to narrow the corresponding portion of the image that would be produced by the resulting mask. Next, the image that would be produced by a mask using the displaced edge fragments is simulated, and the new simulated image is compared with the target image, and the edge placement error for each edge fragment is computed.

This process of moving the edge fragments, simulating the image that would be produced using the moved edge fragments, and comparing the simulated image to the target image may be repeated a number of times. Each cycle of moving edge fragments and comparing the new simulated image to target image is referred to as an iteration of the OPC process. Typically, edge fragments moved during a given iteration, and the distance the edge fragments are displaced, are determined based upon the edge placement error. For example, because d1 is larger than d2 in FIG. 3C, a subsequent iteration of the optical proximity correction process may move edge fragment 301A a greater amount than edge fragment 301C.

The movement value for each edge fragment, often referred to as edge adjustment values or edge displacement values, may be the edge placement error multiplied by a constant factor (feedback factor). This feedback factor may be location dependent or edge type dependent based on the OPC recipe. Methods that consider correlations between neighboring edge fragments such as those described in U.S. Patent Nos. 8,910,098 and 8,881,070, which are both incorporated herein by reference in their entirety, may also be employed to derive the movement value (referred to as cross-MEEF (mask error enhancement factor)-based methods).

The OPC iteration process continues until the simulated image is sufficiently similar to the target image (e.g., both d1 and d2 are smaller than a threshold value), or until it is determined that the displacements of the edge fragments already have converged on locations where no further movement of the edge fragments will improve the simulated image. Once the final positions of the edge fragments are determined in the layout design data, as shown in FIG. 3D, a modified mask feature 303 can be created from the corrected layout design data. As shown in FIG. 3D, the image 304 produced by the modified mask feature 303 should more closely correspond to the target image.

While OPC based on modifying geometric shapes can certainly correct many proximity effects, it does not address one proximity effect-the iso-dense bias problem caused by variations in focus condition. The variations in focus condition become significant when an off-axis illumination scheme (one of the three major resolution enhancement technologies) is optimized for greatest depth of focus of densely placed features. Sub-resolution assist features (SRAFs) can be inserted into the layout design to provide a dense-like environment for isolated features. SRAFs, sometimes also known as "scattered bars," are sub-resolution features not meant to print. They must be carefully adjusted in size and position so that they never print over the needed process window. This determines the most important trade-off in SRAF generation and placement: making the assist features as large and dense as possible in order to create a more dense-like mask pattern, but not so large or dense that they print. Just like the edge-adjustment-based OPC approach, there are rule-based SRAF and model-based SRAF methods. The SRAF insertion is typically performed before or during the edge-adjustment-based OPC process.

### Optical Proximity Correction Tool

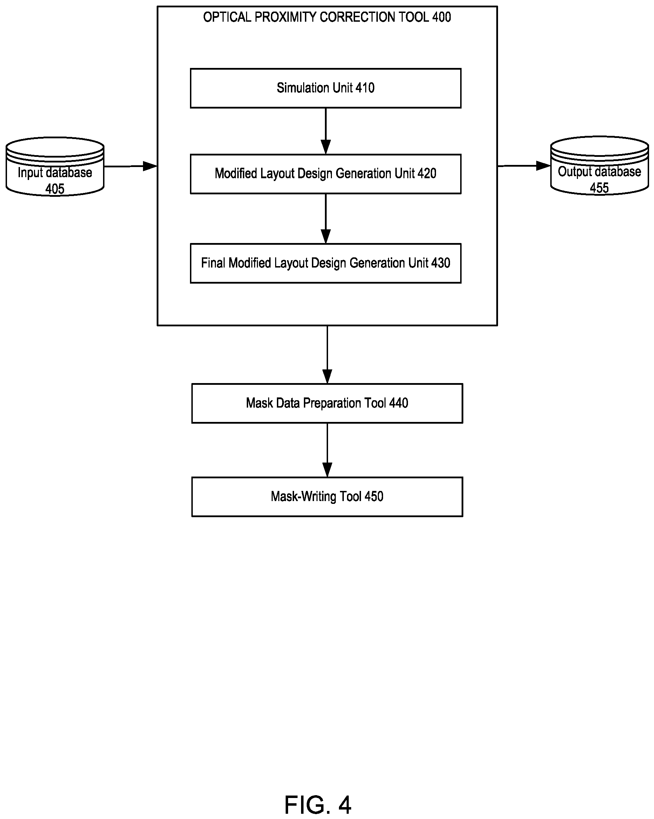

FIG. 4 illustrates an example of an optical proximity correction tool 400 that may be implemented according to various embodiments of the disclosed technology. As seen in this figure, the optical proximity correction tool 400 includes a simulation unit 410, a modified layout design generation unit 420, and a final modified layout design generation unit 430. Some implementations of the optical proximity correction tool 400 may cooperate with (or incorporate) one or more of a mask data preparation tool 440, a mask-writing tool 450, an input database 405 and an output database 455.

As will be discussed in more detail below, the optical proximity correction tool 400 receives a layout design from the input database 405. The layout design may be divided into a plurality of regions. The modified layout design generation unit 420 may be configured to perform a plurality of optical proximity correction iterations on each of the plurality of regions to generate a modified layout design. In one or some embodiments, each of the plurality of optical proximity correction iterations comprises: using the simulation unit 410 to perform simulation to determine edge placement errors for the edge fragments in the each of the plurality of regions, determining intermediate edge adjustment values for the edge fragments in the each of the plurality of regions based on the edge placement errors and a layout pattern in a predetermined-size area surrounding each of the edge fragments such that edge fragments in each of the plurality of regions having the same layout pattern have the same intermediate edge adjustment value, and generating, based on the intermediate edge adjustment values, a modified layout region for the each of the plurality of regions for a next optical proximity correction iteration. The final modified layout design generation unit 430 may be configured to generate a final modified layout design, which may be used for photomask manufacture, based on edge placement errors for the edge fragments in the modified layout design and the layout pattern surrounding each of the edge fragments in the modified layout design such that the edge fragments in different regions in the plurality of regions in the final modified layout design having the same layout pattern have a same edge adjustment value with respect to the layout design. The optical proximity correction tool 400 may store information of the final modified layout design in the output database 455. The mask data preparation tool 440 may be configured to process the final modified layout design to generate mask data. The mask-writing tool 450 may use the mask data to make photomasks.

As previously noted, various examples of the disclosed technology may be implemented by one or more computing systems, such as the computing system illustrated in FIGS. 1 and 2. Accordingly, any one, any combination, or all of the simulation unit 410, the modified layout design generation unit 420, the final modified layout design generation unit 430, and the mask data preparation tool 440 may be implemented by executing programming instructions on one or more processors in one or more computing systems, such as the computing system illustrated in FIGS. 1 and 2. Correspondingly, some other embodiments of the disclosed technology may be implemented by software instructions, stored on a non-transitory computer-readable medium, for instructing one or more programmable computers/computer systems to perform the functions of one or more of the simulation unit 410, the modified layout design generation unit 420, the final modified layout design generation unit 430, and the mask data preparation tool 440. As used herein, the term "non-transitory computer-readable medium" refers to computer-readable medium that are capable of storing data for future retrieval, and not propagating electro-magnetic waves. The non-transitory computer-readable medium may be, for example, a magnetic storage device, an optical storage device, or a solid state storage device.

It also should be appreciated that, while the simulation unit 410, the modified layout design generation unit 420, the final modified layout design generation unit 430, and the mask data preparation tool 440 are shown as separate units in FIG. 4, a single computer (or a single processor within a master computer) or a single computer system may be used to implement some or all of these units at different times, or components of these units at different times.

With various examples of the disclosed technology, the input database 405 and the output database 455 may be implemented using any suitable computer readable storage device. That is, either of the input database 405 and the output database 455 may be implemented using any combination of computer readable storage devices including, for example, microcircuit memory devices such as read-write memory (RAM), read-only memory (ROM), electronically erasable and programmable read-only memory (EEPROM) or flash memory microcircuit devices, CD-ROM disks, digital video disks (DVD), or other optical storage devices. The computer readable storage devices may also include magnetic cassettes, magnetic tapes, magnetic disks or other magnetic storage devices, holographic storage devices, or any other non-transitory storage medium that can be used to store desired information. While the input database 405 and the output database 455 are shown as separate units in FIG. 4, a single data storage medium may be used to implement some or all of these databases.

### Adaptive Target Control

As discussed above, OPC may be applied to a variety of contexts. As one example, OPC may be applied to a layout design that has curves. In one or some embodiments, in curvilinear OPC, the methodology may treat or process different regions or different points differently. Merely by way of example, a first set of points (or regions) in the layout design may be processed differently than a second set of points (or regions). In this way, better results, such as in terms of overall processing time and/or in terms of converging to a feasible solution, may be achieved by prioritizing, improving, or optimizing certain points (or regions) over less important points or regions. Thus, in one or some embodiments, two different sets of points (or regions) are processed differently. Alternatively, more than two different sets of points (or regions) may be processed differently. In this regard, any discussion regarding different sets of points (or regions) may be equally applied to only two different sets or to more than two different sets. Further, any discussion regarding different points in the layout design may be equally applied to different regions in the design.

The selection of the different sets of points (e.g., the more important points versus the less important points) may be performed in one of several ways. Differentiation of points in a layout design may be characterized by any suitable criteria or grouping techniques, and any type of classification or grouping between different point types is contemplated herein (e.g., critical versus non-critical, more important versus less -important, etc.). In one or some embodiments, the selection may be determined by the user. Alternatively, the selection may be based on a procedure that is executed in order to select which points are assigned to which group (e.g., lesser or more important anchor points). In particular, the procedure may generate marker shapes at locations where the verification tool checks that the image is on target (e.g., is on the target image). These marker shapes may be used to identify which spline anchor-points are of particular importance, and in turn, may be designated as more important points, thereby assisting to optimize against one or more criteria that the final result may be measured against. Thus, in one or some embodiments, the selection, which may comprise an automatic selection, may be based on topological considerations.

By way of example, typically, the starting layout design may comprise shapes that contain only horizontal and vertical lines (or potentially 45-degree edges). A curved target may be formed from these shapes, with a mask being created that has curves. In one or some embodiments, the determination of important locations may identify (such as automatically identify) anchor points where the curved target touches the original non-curved edges, and in turn designate such anchor points as more important. Conversely, the exact rounding of corners may be less important than touching these edges, and thus, anchor points associated therewith may be designated (such as automatically designated) as less important points.

Further, responsive to a respective point being assigned to a respective group, various attributes may be assigned to the respective point, such as weightings and/or targets, as discussed in more detail below.

In one or some embodiments, the different processing may be manifested in one of several ways, including any one, any combination, or all of: EPE analysis (e.g., weighted EPE smoothing); target analysis (e.g., weighted target control in which the targets in the target image is changed for one or more anchor points, such as one or more lesser important anchor points); or feedback analysis (e.g., different feedback factors that controls the correction of the EPE). Further, in one or some embodiments, the different processing of the points may be such that the more important points (or most important points or critical points) are prioritized over less important points (or least important points or non-critical points). Thus, in one or some embodiments, the different processing may be such that the processing of a less important point (or points) may be performed so that, at least in part, the EPE of a more important point (or points) are improved.

As one example, weighted EPE, which may weigh the EPEs of the different anchor points differently, may be used to process the less important anchor point(s) differently than the more important anchor point(s). Weighing (such as calculating a weighted average) of a respective anchor point, such as a less important anchor point, results in calculating an effective EPE for the respective anchor point. The weighing may thus enable emphasizing the EPE of certain neighbor anchor points (such as more important directly adjacent neighbor anchor point(s) or more important indirectly adjacent neighbor anchor point(s)) over the respective anchor point. In this way, calculating the effective EPE for the respective anchor point, essentially skewing to give greater weight to the more important neighbor anchor points, may thus result in reducing the EPE for the more important adjacent neighbor anchor point(s).

Various factors may be considered in determining the weight for the respective anchor point and/or for the adjacent anchor points, including any one, any combination, or all of: (i) whether the anchor point is a more important point or a less important point; (ii) distance of a neighboring anchor point from the respective anchor point (whose effective EPE is being calculated); (iii) whether the neighboring anchor point is a directly adjacent anchor point or not; or (iv) whether the neighboring anchor point is a more important anchor point or a less important anchor point. As one example, in one or some embodiments, if the respective anchor point is a more important anchor point, weighting of the EPE is not performed. In such an example, the EPE of the important anchor point may be quantified as the actual EPE, e.g., distance between simulated image and target. Conversely, if the respective anchor point is a less important anchor point, weighting of the EPE is performed, for example in which the weighted EPE is calculated as a weighted sum. A weighted sum may be computed as a sum of the weighted EPE value of the less important anchor point (e.g., as modified by an assigned weight) and the respective weighted EPE values of adjacent anchor points (e.g., as modified by assigned weights).

As another example, the greater the distance of the neighbor anchor point is from the respective anchor point, the lower the weighting. As still another example, determining that the neighboring anchor point is a directly adjacent anchor point results in a higher weighting. Conversely, determining that the neighboring anchor point is not a directly adjacent anchor point (e.g., there is at least one intervening anchor point between the neighboring anchor point and the respective anchor point) results in a lower weighting. As yet another example, determining that the neighboring anchor point is a more important anchor point results in a higher weighting (such as weighting the EPE of the more important anchor point greater than the EPE of the respective anchor point itself). Further, in one or some embodiments, determining that the neighboring anchor point is a less important anchor point may result in not considering the EPE of the neighboring anchor point at all, effectively weighting the EPE of the less important neighboring anchor point as zero.

In one particular example, a respective less important point may have an associated EPE and may have neighboring more important point(s) (such as directly adjacent neighboring more important point(s) or indirectly adjacent neighboring more important point(s)) with their associated EPEs. In one or some embodiments, the weighting of one or both of the EPE of the respective less important point or of the neighboring more important point(s) may be selected such that in the methodology, in seeking to reduce the EPE of the respective point, also may reduce the EPE of the neighboring more important point(s).

In a first numerical example, the EPE (e.g., unweighted EPE) of the respective less important point may be less than the EPE of the neighboring more important point(s). With weighting (such as weighting the EPE of the respective less important point lower and/or weighting the EPE of the neighboring more important point(s) higher), the effective EPE may be numerically greater than the actual EPE (e.g., unweighted EPE) for the respective less important point. In a more specific first numerical example, the EPE of the respective less important point may be zero, whereas the EPEs of the neighboring more important point(s) are greater than zero. With weighting, an OPC iteration may still change the position of the respective less important point(even with zero EPE) in order to reduce the EPE of the neighboring more important point(s). Thus, processing the first numerical example with the weighting effectively results in the changing of the position of the respective less important point more (due to the weighting) and also results in reducing the EPE for the neighboring more important point(s). In a second numerical example, the EPE of the respective less important point may be greater than the EPE of the neighboring more important point(s). With weighting, the effective EPE may be less than the actual EPE for the respective less important point. Thus, processing the second numerical example with the weighting effectively results in the changing the position of the respective less important point less (due to the weighting), so that the change is less likely.

As another example, target control, such as weighted target control, may be used to process the less important point(s) differently than the more important point(s). As discussed above, targets (e.g., in a target image) are an indication of where the respective point is desired to be located, with the EPE being a measure of the difference between the simulated location of respective point and the target of the respective point. In one or some embodiments, the targets of one or more of the points (such as one or more of the less important points) may be dynamically changed in order to reduce the EPE of other point(s) (such as one or more of the more important points whose target(s) do not change). In this way, shifting or modifying the target for the less important points result in the OPC seeking to put the nominal image in a slightly different location. Further, the shifting or modifying of the target may be performed in order to reduce or eliminate the EPE for the more important points, thereby effectively having the image pass through the more important points. In this regard, shifting or modifying the target during OPC may make the problem of reducing or eliminating the EPE for the more important points more feasible.

In one or some embodiments, the changing of the target for the respective point may be dependent (such as at least partly dynamically dependent) on a neighbor (such as dependent on the EPE(s) of directly adjacent neighboring more important point(s)). For example, in one or some embodiments, the determination as to whether to change the target for the respective point and/or how much to change the target for the respective point may be dependent on any one, any combination, or all of: (i) whether the respective point is a less important point or not; (ii) whether the EPE for the respective point is the same sign as a neighboring point (such as the same sign as a more important neighboring point); or (iii) what the values of the EPE are for the respective point and/or for the neighboring point(s)). As one example, in one or some embodiments, changing the target for the respective point may only be performed for a less important anchor point. Conversely, changing the target for the respective point may not be performed for a more important anchor point.

As another example, in one or some embodiments, whether to change the target for a respective point (such as a less important anchor point) is dependent on whether the sign of the EPE is the same for the respective less important point versus a neighboring more important point. A sign may refer to a positive sign (+) or negative sign (-), or any indicator for an EPE value indicative of a direction in which an anchor point in a simulated image differs from a target. Thus, if the signs of the EPE are the same, the target for the respective less important point is not changed. This may indicate that further adjustments of the less important and more important anchor points through the OPC iterations will move in the same direction since the sign of their respective EPEs are the same. As such, target control may not be necessary as both anchor points will be adjusted in the same direction and there is no conflict in movement directions between the two anchor points. Similarly, if the EPE is zero for both the respective less important point and the neighboring more important point, then changing the target for the respective less important point is not performed. Conversely, if the signs of the EPE of the respective less important point and the neighboring more important point are different (e.g., one has a positive EPE and the other has a negative EPE), target control is performed and the target for the respective less important point is changed. This may be the case as OPC adjustments for the two anchor points will be in different directions to move toward respective targets, and there is a conflict between the two points as to reducing EPE. In such cases, target control may be performed on the less important anchor point in order to reduce the conflicting movements between the anchor points and instead prioritize EPE reduction of the more important anchor point, e.g., through prioritizing movement of the more important anchor point towards its target via target control for the less important anchor point. As another example, target control may be performed when the EPE of the respective less important point is zero and the EPE of the respective more important point is non-zero (either positive or negative), doing so to allow movement of the more important anchor point even though the EPE of the respective less important is already at zero. In such cases, movement of the target to make the effective EPE of the respective less important point non-zero will allow OPC iterations to adjust the location of the more important anchor point and reduce its EPE.

As yet another example, the amount that the target for the respective less important point is changed may be dependent on the EPE of the neighboring more important point(s). In one particular example, the higher the EPE of the neighboring more important point(s), the greater the change in the target for the respective less important point. However, in one or some embodiments, an upper limit may be enforced such that the amount of change in the target may be limited (e.g., to no more than ±2nm). Thus, once the amount of change is determined, the direction of the change in the target may be determined as well. For example, a negative EPE may result in the target being moved outward from the target curve, whereas a positive EPE may result in the target being moved further inward with regard to the target curve. Moreover, in one or some embodiments, the direction of movement of the target may be perpendicular to the target curve, e.g., at an angle that is perpendicular to point of the curve at the location of the less important anchor point and in a direction to reduce the EPE of the more important anchor point. In this way, changing the target of the respective less important point may enable positioning the more important point closer to its respective non-changing target. In one or some embodiments, the amount to change the target for the less important point may be based on weighting (e.g., weighting the EPE of the neighboring more important point(s) greater than the EPE of the respective less important point).

Thus, in one numerical example, the EPE of the respective less important point may be less than the EPE of the neighboring more important point(s). In such an instance, the new target for the respective less important point may be selected in order to move the neighboring more important point(s) closer to their respective targets (even if the EPE of respective less important point is zero).

As still another example, a feedback factor may be used to process the less important point(s) differently than the more important point(s). In particular, a feedback factor, which may be constant or adaptive, may control the amount of correction of the EPE (e.g., a larger shift versus a smaller shift) in the iterative optimization. In this regard, the amount of correction may be controlled by the feedback factor, which may be different for the more important point(s) versus the less important point(s) (e.g., a smaller shift for the less important point(s) versus a larger shift for the more important point(s)).

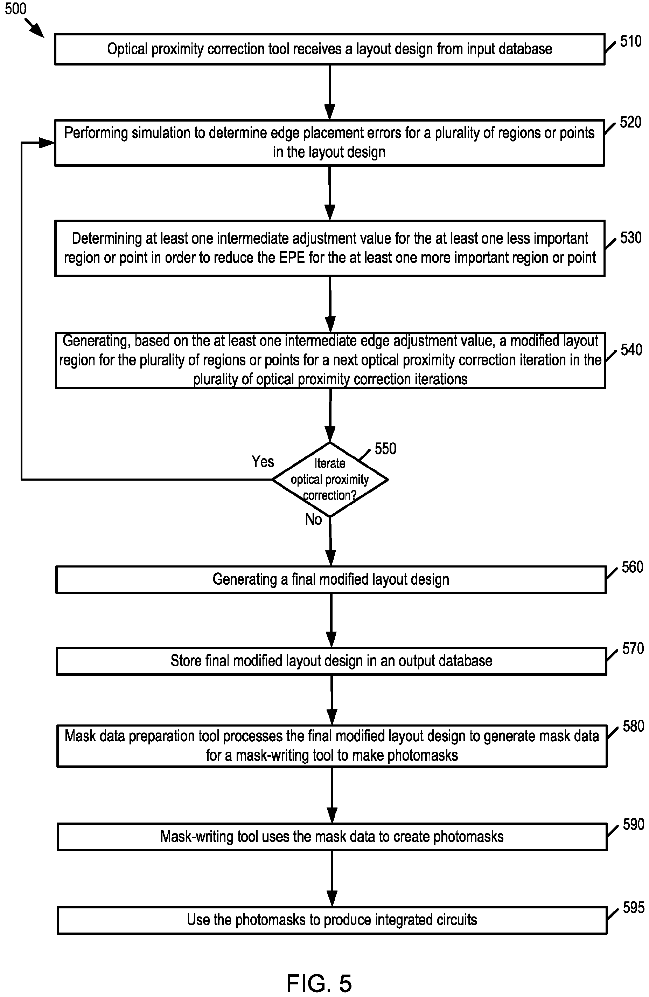

FIG. 5 illustrates a flow chart 500 showing a process of optical proximity correction that may be implemented according to various examples of the disclosed technology. For ease of understanding, methods of optical proximity correction that may be employed according to various embodiments of the disclosed technology will be described with reference to the optical proximity correction tool 400 in FIG. 4 and the flow chart 500 illustrated in FIG. 5. It should be appreciated, however, that alternate implementations of an optical proximity correction tool may be used to perform the methods of optical proximity correction illustrated by the flow chart 500 according to various embodiments of the disclosed technology. Likewise, the optical proximity correction tool 400 may be employed to perform other methods of optical proximity correction according to various embodiments of the disclosed technology.

At 510 of the flow chart 500, the optical proximity correction tool 400 receives a layout design from the input database 405. The layout design, derived from a circuit design, may be in the GDSII standard format. The layout design can be one for a whole chip or a portion of a full-chip layout design. The layout design is divided into a plurality of regions. The plurality of regions may be array of rectangle or square regions. Alternatively, the plurality of regions may include different shapes of regions. The size may be several pm or ten pm. These regions are sometimes referred to as tiles or windows.

In operation , the modified layout design generation unit 420 may perform a plurality of optical proximity correction iterations on each of the plurality of regions to generate a modified layout design. This is illustrated at 550 when determining whether to iterate optical proximity correction. As discussed previously, optical proximity correction may be an iterative process.

At 520 of flow chart 500, one or more simulations may be performed to determine edge placement errors (EPEs) for a plurality of regions or points in the layout design. At 530 of flow chart 500, at least one intermediate adjustment value may be determined for the at least one less important region or point in order to reduce the EPE for the at least one more important region or point. As discussed above and in additional detail below, various methodologies, including weighted EPE smoothing, weighted target control, and/or feedback control, may be used to generate the at least one intermediate adjustment value.

At 540 of flow chart 500, based on the at least one intermediate edge adjustment value, a modified layout region is generated for the plurality of regions or points for a next optical proximity correction iteration in the plurality of optical proximity correction iterations.

At 560, the final modified layout design generation unit 430 generates a final modified layout design based on the modified layout design. At 570, the optical proximity correction tool 400 stores information of the final modified layout design in the output database 455. Optionally, at 580, the mask data preparation tool 440 processes the final modified layout design to generate mask data for a mask-writing tool to make photomasks. The mask-writing tool can be raster scan-based-either electron beams or laser beams constantly scan in a predetermined pattern. In this approach, the mask data preparation tool 440 converts the layout data into primitive shapes (rectangles and trapezoids), which is sometimes referred to as mask data fracturing. Alternatively, the mask-writing tool can use a variable-shaped beam-a larger beam is shaped by an aperture into a primitive shape (usually a rectangle or a trapezoid), and the image of the aperture is projected in individual "flashes" at appropriate locations. For this approach, the mask data preparation tool 440 fractures the layout design into shots of acceptable size and the appropriate stage motion instructions for creating the pattern. Additionally, the mask data preparation tool 440 may perform mask process correction (MPC). Although the photomask features are typically used in a 4× reduction system, and the feature dimensions are thus 4 *×* larger than on the wafer, there may still be a need to accurately fabricate SRAF and other OPC jogs and structures that are significantly smaller. Mask process correction attempts to correct charged particle proximity effects.

Still optionally, at 590, the mask-writing tool 450 uses the mask data to create photomasks. Still optionally, at 595, the photomasks may be used to produce integrated circuits (e.g., fabricate chips) through photolithography.

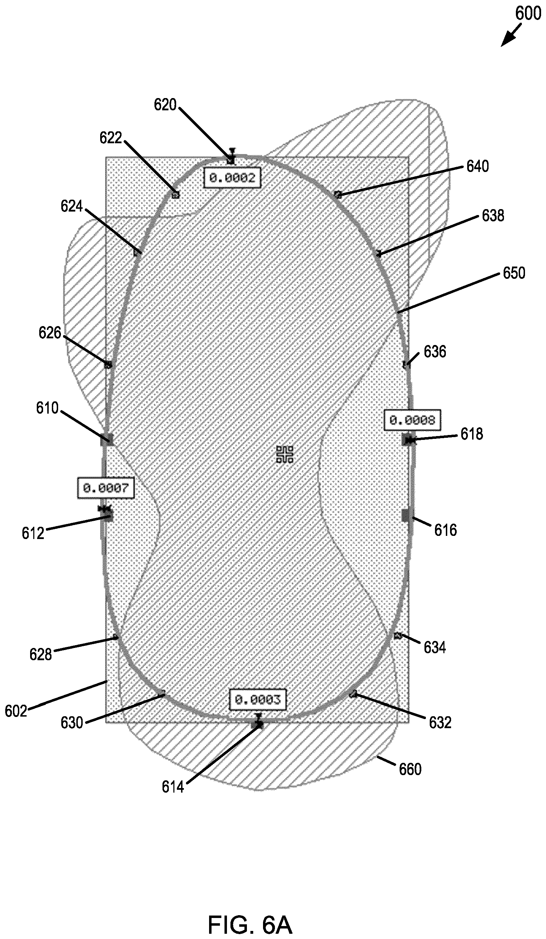

FIGS. 6A-B schematically illustrate weighted EPE smoothing in order to reduce EPE. Specifically, FIG. 6A is an illustration 600 of a layout feature 602, with a simulation being performed to obtain the predicted printed image 650 for the layout feature 602 and the associated mask 660. Thus, the layout designer may supply layout feature 602 and predicted printed image 650 is a representation of what the final silicon is predicted to look like. The final result of the predicted printed image 650 is shown as asymmetric in FIG. 6A because the larger design is asymmetric and diffracts light onto layout feature 602 in a way that distorts what may be achievable. Moreover, in one or some embodiments, predicted printed image 650 may actually be the nominal image for the simulation of the photoresist, and not the target itself in this image (though it may be very close to the target).

Further, FIG. 6A illustrates more important points 610, 612, 614, 616, 618 and less important points 620, 622, 624, 626, 628, 630, 632, 634, 636, 638, 640. In this regard, the locations which are of greatest importance are more important points 610, 612, 614, 616, 618 whereas less important points 620, 622, 624, 626, 628, 630, 632, 634, 636, 638, 640 are less critical. The various points, including the more important points 610, 612, 614, 616, 618 and the less important points 620, 622, 624, 626, 628, 630, 632, 634, 636, 638, 640, may be connected by cubic-bezier spline segments. As shown in FIG. 6A, the EPE for more important point 612 is 0.0007pm and more important point 618 is 0.0008pm.

In one or some embodiments, a respective point, such as one or more of the less important points 620, 622, 624, 626, 628, 630, 632, 634, 636, 638, 640, may have a weighted or effective EPE, which may be used for weighted EPE smoothing. In one or some embodiments, the weighted EPE for a respective point may be based on one or both of the: (i) the EPE of the respective point; and (ii) the EPE of one or more neighbor points. More specifically, in one or some embodiments, for a respective less important point, the EPE of the neighboring more important point(s) may be given greater weight (such as greater weight than the EPE as measured for the respective less important point).

In one or some embodiments, weighting may be used to indicate importance (e.g., a lower weighting associated with an anchor point indicating a less important point and a higher weighting associated with an anchor point indicating a more important point). In one or some embodiments, weights may be on a scale, such as a sliding scale, between 0 (indicating less or least important) and 1 (indicating more or most important). In one or some embodiments, by default, all anchor points have a weight of 1. Further, anchor points with weight of 1 may be deemed higher importance or critical. In practice, such higher important points have no target control applied to them, as discussed further below. Moreover, for these higher important points, the methodology may seek to achieve the a different objective (e.g., EPE ~ 0nm) with respect to the original target. For the remaining less important points, weighting and/or target control may be used.

Merely by way of example, the EPE of the directly adjacent neighboring more important point(s) may be weighted as 1, whereas the EP of the respective less important point may be weighted as .3, resulting in an effective EPE for the respective less important point being weighted in favor of considering the EPEs for the directly adjacent neighboring more important point(s). In this way, OPC iterations, using the effective EPE, may better reduce the EPEs for the more important points.

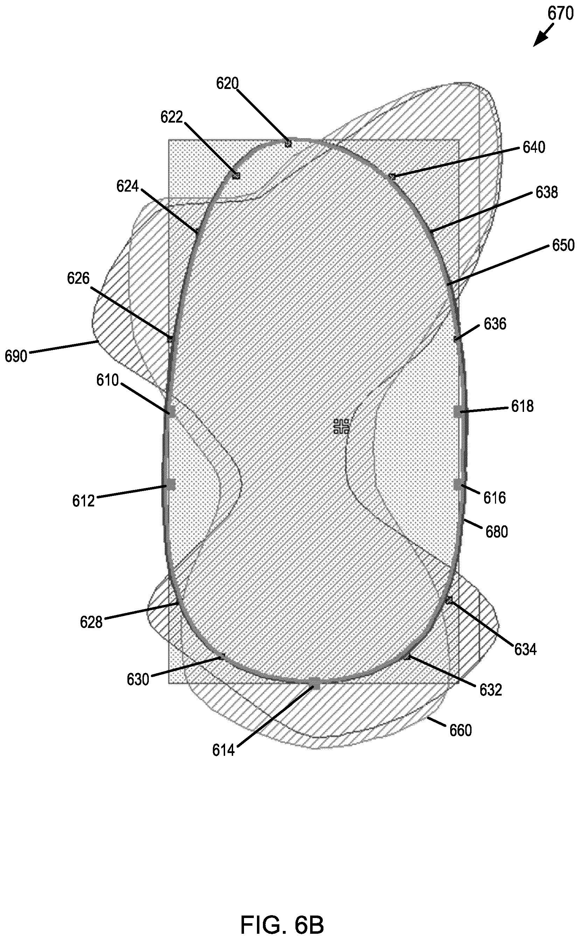

This is shown in the illustration 670 in FIG. 6B, in which the weighted EPEs for one or more of the less important points 620, 622, 624, 626, 628, 630, 632, 634, 636, 638, 640 results in the predicted printed image 680 for the layout feature 602 and the associated mask 690 with an EPE for one or more of the more important points 610, 612, 614, 616, 618 being reduced.

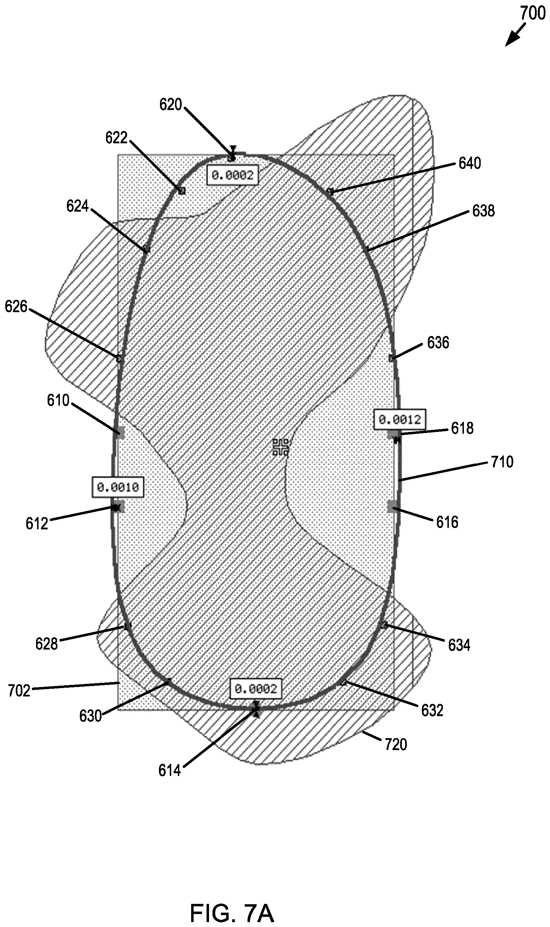

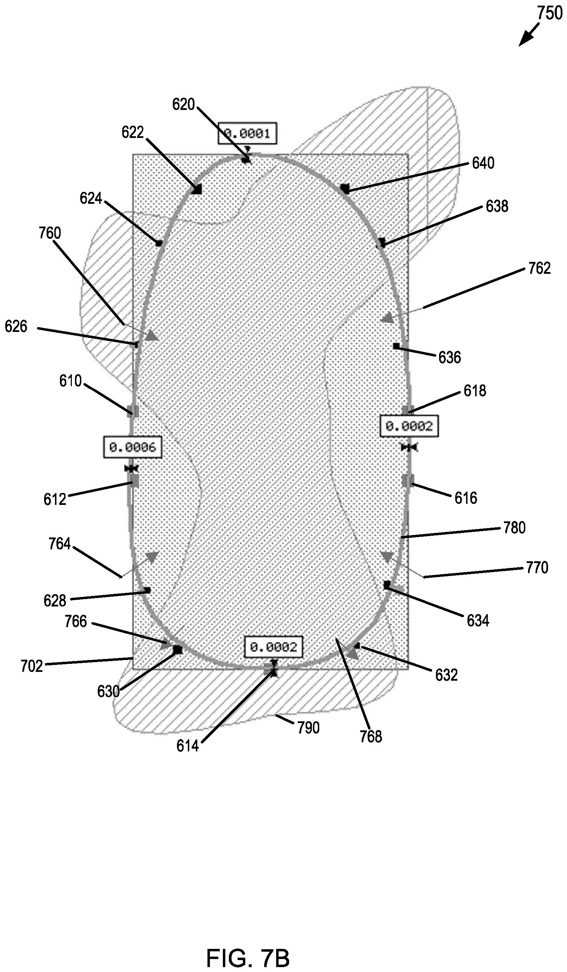

FIGS. 7A-B schematically illustrate weighted target control in order to reduce EPE. Specifically, FIG. 7A is an illustration 700 of a layout feature 702, with a simulation being performed to obtain the predicted printed image 710 for the layout feature 702 and the associated mask 720. As shown in FIG. 7A, the predicted printed image 710 is slightly off-target on the sides (at more important points 610, 612, 616, 618) but on-target for the less important points 626, 628, 630, 632, 636, 638. Even though the less important points 626, 628, 630, 632, 636, 638 are on target, the targets are changed in order to improve the positioning of more important points 610, 612, 616, 618, as illustrated in FIG. 7B.

Specifically, FIG. 7B is an illustration 750 in which the target for one or more of the 620, 622, 624, 626, 628, 630, 632, 634, 636, 638, 640 is changed or revised in order to reduce the EPE for one or more of the more important points 610, 612, 614, 616, 618. The changes in the targets are illustrated by arrows 760, 762, 764, 766, 768, 770, in which the target for less important point(s) is moved in order to improve the EPE for more important point(s). In one or some embodiments, an amount by which the target may be changed may be limited, such as ±2nm. Further, after target shifting, the mask 790 may be represented as shown in FIG. 7B.

By way of example, arrow 764 indicates that the target for less important point 628 is moved inward/upward so that when processing the next OPC iteration, the EPE for more important point 612 is reduced from .0010µm to .0006µm. Thus, the change in the value of the target for the less important point(s) may be dependent on the EPE of neighboring more important points. In particular, one or both of the amount of change of the target and the direction of the change of the target may be dependent and automatically determined based on the placement of the predicted image at the neighboring more important point(s). For example, the predicted printed image 710 at more important point 612 is simulated to be to the left of more important point 612. Therefore, to move the predicted printed image 710 at more important point 612, the target for the neighboring less important point 628 is moved rightward and/or upward. In this way, the printed image 710 at more important point 612 is then moved further inward so that the EPE at more important point 612 is reduced.

Similarly, arrow 762 indicates that the target for less important point 636 is moved inward/downward so that when processing the next OPC iteration, the EPE for more important point 618 is reduced from .0012µm to .0002µm. In one or some embodiments, the target for only one less important point is changed in order to improve the EPE for a neighboring more important point. Alternatively, the target for a plurality of less important points are changed in improve the EPE for a neighboring more important point. By way of example, changing targets for less important points 634, 636 (as shown by arrows 762, 770) may change the EPEs for both more important points 616, 618. Thus, in certain instances, the EPE of a respective less important point may be zero or negligible. Nevertheless, in order to improve the EPE for a neighboring more important point, the original target of the respective less important point is changed, resulting in increasing the EPE for the respective less important point as measured relative to the original target. In this way, even though the EPE for the respective less important point increases (relative to the original target), changing the target for the respective less important point may result in decreasing the EPE for a neighboring more important point.

### Conclusion

The above disclosed subject matter is to be considered illustrative, and not restrictive, and the appended claims are intended to cover all such modifications, enhancements, and other embodiments, which fall within the true spirit and scope of the description. Thus, to the maximum extent allowed by law, the scope is to be determined by the broadest permissible interpretation of the following claims and their equivalents, and shall not be restricted or limited by the foregoing detailed description. Further, while the disclosed technology has been described with respect to specific examples including presently preferred modes of carrying out the disclosed technology, those skilled in the art will appreciate that there are numerous variations and permutations of the above described systems and techniques that fall within the spirit and scope of the disclosed technology as set forth in the appended claims. For example, while specific terminology has been employed above to refer to electronic design automation processes, it should be appreciated that various examples of the disclosed technology may be implemented using any desired combination of electronic design automation processes.

## Claims

1. A method, executed by at least one processor of a computer, comprising:
receiving a layout design, the layout design being segmented into a plurality of points, the plurality of points comprising at least one more important point and at least one less important point;
performing a plurality of optical proximity correction iterations on the plurality of points to generate a modified layout design, each of the plurality of optical proximity correction iterations comprising:
performing simulation to determine edge placement errors (EPE) for the plurality of points;
determining at least one intermediate adjustment value for the at least one less important point in order to reduce the EPE for the at least one more important point; and
generating, based on the at least one intermediate edge adjustment value, a modified layout design for the plurality of points for a next optical proximity correction iteration in the plurality of optical proximity correction iterations; and
generating a final modified layout design, which is to be used for photomask manufacture, based on the modified layout design; and
storing information of the final modified layout design.

2. The method of claim 1, wherein determining at least one intermediate adjustment value for the at least one less important point in order to reduce the EPE for the at least one more important point comprises:
using different weights for the EPE for the at least one more important point and for the at least one less important point in order to determine the at least one intermediate adjustment value.

3. The method of claim 2, wherein calculating the EPE for the at least one less important point comprises calculating an effective EPE for the at least one less important point that weights the EPE for a neighboring more important point higher than the EPE for the at least one less important point.

4. The method of claim 3, wherein weighting the EPE for the neighboring more important point higher than the EPE for the at least one less important point comprising weighting the EPE for the at least one less important point to be less than 1.

5. The method of claim 1, wherein determining at least one intermediate adjustment value for the at least one less important point in order to reduce the EPE for the at least one more important point comprises:
changing a target for the at least one less important point.

6. The method of claim 5, wherein the target for the at least one less important point is dynamically determined.

7. The method of claim 6, wherein the target for the at least one less important point is dynamically determined based on a value of the EPE of a neighboring more important point.

8. The method of claim 1, wherein determining at least one intermediate adjustment value for the at least one less important point in order to reduce the EPE for the at least one more important point comprises:
using different feedback factors for the at least one less important point and for the at least one more important point in generating the at least one intermediate adjustment value.

9. A method, executed by at least one processor of a computer, comprising:
receiving a layout design, the layout design being segmented into a plurality of points;
performing a plurality of optical proximity correction iterations on the plurality of points to generate a modified layout design, each of the plurality of optical proximity correction iterations comprising:
performing simulation to determine edge placement errors (EPE) for the plurality of points;
dynamically changing targets for one or more of the plurality of points in determining at least one intermediate adjustment value for one or more of the plurality of points; and
generating, based on the at least one intermediate edge adjustment value, a modified layout design for the plurality of points for a next optical proximity correction iteration in the plurality of optical proximity correction iterations; and
generating a final modified layout design, which is to be used for photomask manufacture, based on the modified layout design; and
storing information of the final modified layout design.

10. The method of claim 9, wherein the plurality of points comprises a first set of a plurality of points and a second set of a plurality of points;
wherein the targets for the first set of the plurality of points are dynamically determined; and
wherein the targets for the second set of the plurality of points are constant.

11. The method of claim 10, wherein the first set of the plurality of points are designated as lesser important anchor points in the layout design; and
wherein the second set of the plurality of points are designated as more important anchor points in the layout design.

12. The method of claim 11, wherein changing the targets for the lesser important anchor points is at least partly dependent on the EPE of at least one important neighbor point.

13. The method of claim 12, wherein changing the target for at least one lesser important anchor point results in increasing the EPE for the at least one lesser important anchor point relative to an original target for the at least one lesser important anchor point.

14. One or more non-transitory computer-readable media storing computer-executable instructions for causing one or more processors to perform a method according to any of claims 1-8.
